# EUROPEAN PATENT APPLICATION

(11) **EP 4 723 476 A2**
(43) Date of publication of application: **08.04.2026**
(21) Application number: 26159782.7
(22) Date of filing: 20.12.2024
(51) Int. Cl.: H03F 3/16

(54) **DEVICE INCLUDING STRUCTURE FOR PROTECTING ELEMENTS IN POWER DOWN MODE**

(30) Priority: 27.12.2023 KR 20230193184; 22.04.2024 KR 20240053541
(62) Divisional of application: 24222346.9
(71) Applicant: Samsung Electronics Co., Ltd., Suwon-si, Gyeonggi-do 16677 (KR)
(72) Inventor: PARK, Himchan, 16677 Suwon-si (KR); KIM, Jooseong, 16677 Suwon-si (KR); YANG, Junhyeok, 16677 Suwon-si (KR); YOO, Sungmin, 16677 Suwon-si (KR); CHOI, Haejung, 16677 Suwon-si (KR)
(74) Representative: Marks & Clerk LLP

(57) **Abstract**

A device includes: a plurality of first transistors included in a first current path, in a normal mode, between a first power node to which a positive supply voltage is configured to be applied and a second power node to which a negative supply voltage is configured to be applied; and a first protection transistor connected to a first node which two of the plurality of first transistors are connected to, wherein the first protection transistor is configured to be turned off in the normal mode and to be turned on to provide a protection voltage to the first node in a power down mode.

## Description

### BACKGROUND

The embodiments of the disclosure relate to a device for protecting transistors, and more particularly to, a device including a transistor that protects other transistors in a power down mode.

An integrated circuit may include elements such as transistors, and the elements may have a withstand voltage to operate normally. For example, when a voltage exceeding the withstand voltage is applied to an element, the element may not provide a desired operation or may be damaged. Accordingly, an integrated circuit may include a structure for protecting elements from voltages exceeding the withstand voltage. An integrated circuit may support a power down mode, and may be required to protect the elements from voltages exceeding the withstand voltage even in the power down mode.

Information disclosed in this Background section has already been known to the inventors before achieving the disclosure of the present application or is technical information acquired in the process of achieving the disclosure. Therefore, it may contain information that does not form the prior art that is already known to the public.

### SUMMARY

The disclosure provides a device including a structure that protects elements in a power down mode.

According to an aspect of the disclosure, there is provided a device including: a plurality of first transistors included in a first current path between a first power node to which a positive supply voltage is configured to be applied and a second power node to which a negative supply voltage is configured to be applied, in a normal mode; and a first protection transistor connected to a first node at which two of the plurality of first transistors are connected to, wherein the first protection transistor is configured to be turned off in a normal mode, and to be turned on to provide a protection voltage to the first node in a power down mode.

According to another aspect of the disclosure, there is provided a device including: a plurality of first transistors included in a first current path, in a normal mode, between a first power node to which a positive supply voltage is configured to be applied and a second power node to which a negative supply voltage is configured to be applied; and a protection transistor connected to a gate of a first multi-function transistor among the plurality of first transistors, wherein the protection transistor is configured to be turned off in the normal mode, and to be turned on to provide a protection voltage to the gate of the first multi-function transistor in a power down mode.

According to still another aspect of the disclosure, there is provided a device including: an input stage circuit configured to generate complementary amplification signals from complementary input signals, in a normal mode; an output stage circuit configured to generate complementary output signals from the complementary amplification signals, in the normal mode; and a bias circuit configured to provide at least one bias voltage to each of the input stage circuit and the output stage circuit; wherein the input stage circuit comprises a first protection transistor and a second protection transistor respectively connected to a first node and a second node at which the complementary amplification signals are generated, respectively, and the first protection transistor and the second protection transistor are configured to be turned off in the normal mode and to be turned on to respectively provide a first protection voltage to each of the first node and the second node in a power down mode.

A power down mode may be defined as a mode of operation in which a device does not consume any power. A normal mode may be defined as a mode of operation in which a device consume at least some power. A power down mode and/or a normal mode may apply to the described plurality of first transistors. That is to say, the plurality of first transistors may consume no power in a power down mode, and may consume at least some power in a normal mode.

At least some of the above and other features of the disclosure are set out in the claims.

### BRIEF DESCRIPTION OF DRAWINGS

Embodiments will be more clearly understood from the following detailed description taken in conjunction with the accompanying drawings in which:
FIG. 1 is a block diagram illustrating a device according to one or more embodiments;
FIGS. 2A to 2D are diagrams illustrating examples of transistors according to one or more embodiments;
FIG. 3 is a circuit diagram illustrating an amplifier according to one or more embodiments;
FIG. 4 is a graph illustrating a protection voltage according to one or more embodiments;
FIGS. 5A and 5B are circuit diagrams illustrating examples of current paths according to some embodiments;
FIG. 6 is a circuit diagram illustrating an amplifier according to one or more embodiments;
FIG. 7 is a circuit diagram illustrating a current path according to one or more embodiments;
FIG. 8 is a circuit diagram illustrating an amplifier according to one or more embodiments;
FIG. 9 is a circuit diagram illustrating a current path according to one or more embodiments;
FIG. 10 is a circuit diagram illustrating an amplifier according to one or more embodiments;
FIG. 11 is a timing diagram illustrating an operation of a device according to one or more embodiments; and
FIG. 12 is a block diagram illustrating a system-on-chip (SoC) according to one or more embodiments.

### DETAILED DESCRIPTION

Various embodiments of the disclosure will be described herein in reference to the accompanying drawings. The embodiments described herein are non-limiting example embodiments, and thus, the disclosure is not limited thereto and may be realized in various other forms. Each of the embodiments provided herein is not excluded from being associated with one or more features of another example or another embodiment also provided herein or not provided herein but consistent with the disclosure. For example, even if matters described in a specific example or embodiment are not described in a different example or embodiment, the matters may be understood as being related to or combinable with the different example or embodiment, unless otherwise mentioned in descriptions thereof.

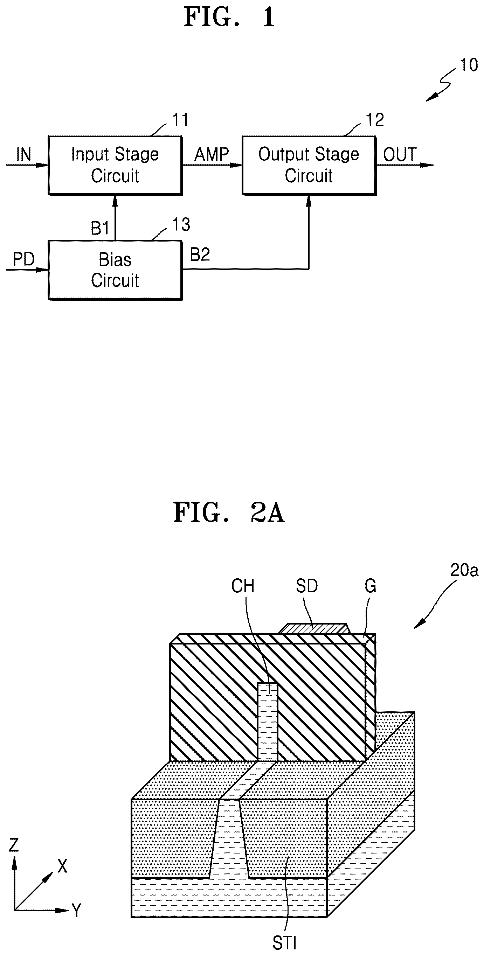

FIG. 1 is a block diagram illustrating a device 10 according to one or more embodiments. For example, the block diagram of FIG. 1 shows the device 10 functioning as an amplifier that generates an output signal OUT by amplifying an input signal IN. Hereinafter, as shown in FIG. 1, the device 10 functioning as an amplifier will be mainly described, but it is noted that some embodiments are not limited to the device 10 of FIG. 1. As shown in FIG. 1, the device 10 may include an input stage circuit 11, an output stage circuit 12, and a bias circuit 13. Herein, an input stage circuit may be referred to as an input stage, and an output stage circuit may be referred to as an output stage.

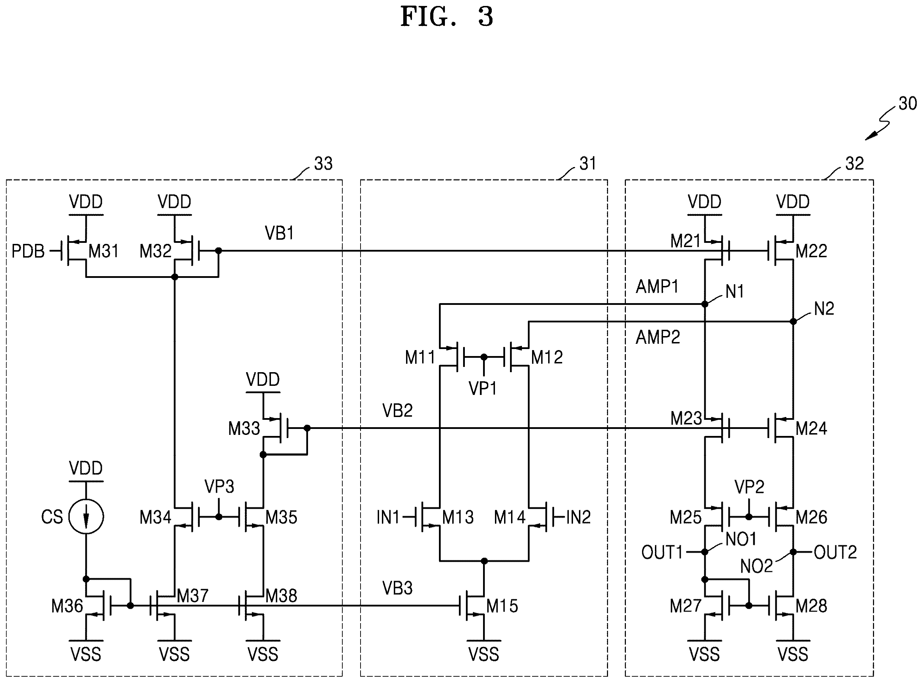

The input stage circuit 11 may receive the input signal IN and may generate an amplification signal AMP by amplifying the input signal IN. In some embodiments, the input stage circuit 11 may have a non-inverting input and an inverting input. The input signal IN may include two signals (e.g., IN1 and IN2 of FIG. 3) provided to the non-inverting input and the inverting input, respectively, and the input stage circuit 11 may generate the amplification signal AMP by amplifying a difference between the two signals. In some embodiments, the amplification signal AMP may include complementary signals. Examples of the input stage circuit 11 will be described later with reference to the drawings.

The output stage circuit 12 may receive the amplification signal AMP and generate the output signal OUT from the amplification signal AMP. In some embodiments, the output stage circuit 12 may have a high current driving capability and may provide a low output impedance at an output node where the output signal OUT is generated. Examples of the output stage circuit 12 will be described later with reference to the drawings.

The bias circuit 13 may generate bias voltages. For example, as shown in FIG. 1, the bias circuit 13 may provide at least one first bias voltage B1 to the input stage circuit 11, and the input stage circuit 11 may generate the amplification signal AMP from the input signal IN based on the at least one first bias voltage B1. In addition, the bias circuit 13 may provide at least one second bias voltage B2 to the output stage circuit 12, and the output stage circuit 12 may generate the output signal OUT from the amplification signal AMP based on the at least one second bias voltage B2.

The device 10 may receive a positive supply voltage and a negative supply voltage, and may operate based on power provided by the positive supply voltage and the negative supply voltage. For example, each of the input stage circuit 11, output stage circuit 12, and bias circuit 13 may be connected to a first power node to which the positive supply voltage is applied and/or a second power node to which the negative supply voltage is applied, and may operate based on a current flowing from the first power node to the second power node.

The device 10 may support a power down mode. For example, the device 10 may perform an operation of generating the output signal OUT from the input signal IN in a normal mode, and may not consume power in the power down mode. In another example, the device may not consume any power in a power down mode, and may consume at least some power in a normal mode. As another example, as shown in FIG. 1, the bias circuit 13 may receive a power down signal PD, and when the power down signal PD is activated, in the power down mode, the power consumed by the input stage circuit 11 and the output stage circuit 12 may be cut off by adjusting the at least one first bias voltage B1 and the at least one second bias voltage B2. In some embodiments, the input stage circuit 11 and/or the output stage circuit 12 may receive the power down signal PD. Herein, the power down signal PD is assumed to be an active high signal, and accordingly, the activated power down signal PD may have a high level, and the inactivated power down signal PD may have a low level. Herein, the power down signal PD may be referred to as a control signal.

In some embodiments, the device 10 may include an integrated circuit manufactured by a semiconductor process. For example, the integrated circuit may be manufactured by patterning a plurality of layers by using at least one mask. A front-end-of-line (FEOL) process may include, for example, an operation of planarizing and cleaning a wafer, an operation of forming a trench, an operation of forming a well, an operation of forming a gate electrode, and an operation of forming a source and a drain. Individual elements such as transistors, capacitors, resistors, etc. may be formed on a substrate by the FEOL process. Examples of transistors will be described below with reference to FIGS. 2A to 2D. In addition, a back-end-of-line (BEOL) process may include, for example, an operation of silicidating gate, source and drain regions, an operation of adding dielectric, an operation of planarization, an operation of forming holes, an operation of adding a metal layer, an operation of forming vias, an operation of forming a passivation layer, etc. Individual elements, such as transistors, capacitors, resistors, etc., may be interconnected by the BEOL process. In some embodiments, a middle-of-line (MOL) process may be performed between the FEOL and the BEOL, and contacts may be formed on individual elements. The integrated circuit may then be packaged in a semiconductor package and used as a component for various applications.

Each of the input stage circuit 11, the output stage circuit 12, and the bias circuit 13 may include elements, such as transistors. A transistor may have a withstand voltage for a normal operation. For example, when a voltage exceeding the withstand voltage is applied to the transistor, the transistor may not provide the desired operation or may even be damaged. The transistor may have different withstand voltages according to a structure and/or composition, and the withstand voltage of the transistor may decrease due to various factors. For example, when the size of the transistor decreases or the structure of the transistor changes, the withstand voltage may decrease. Accordingly, the device 10 may include a structure for protecting transistors from the voltage exceeding the withstand voltage. In some embodiments, the device 10 may include a transistor to which a voltage applied in the normal mode and a voltage applied in the power down mode are different from each other. As will be described below with reference to the drawings, a structure for protecting a transistor may protect transistors from the voltage exceeding the withstand voltage not only in the normal mode but also in the power down mode. In addition, the structure for protecting the transistor may not cause degradation of performance of the device 10 when the device 10 is operating in the normal mode. In addition, the structure for protecting the transistor may be minimized, and accordingly, the device 10 may achieve area reduction, i.e., the device 10 may be of minimal size.

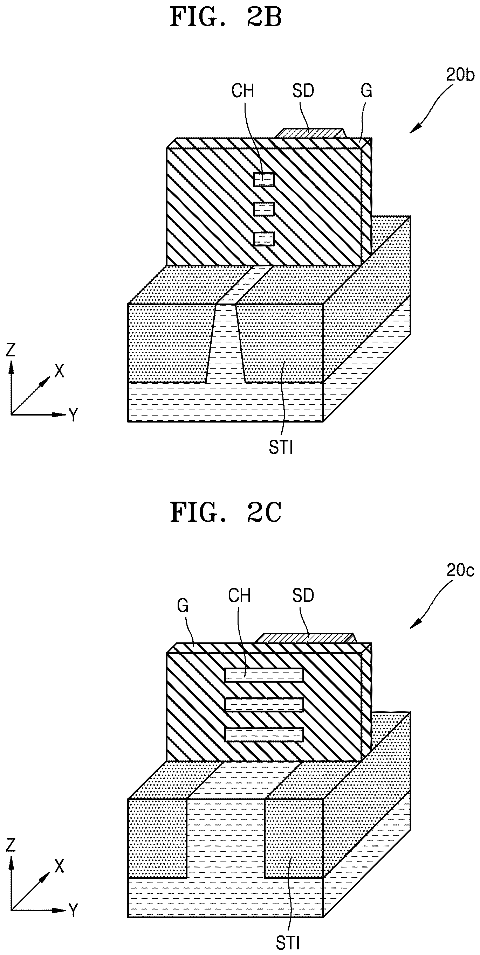

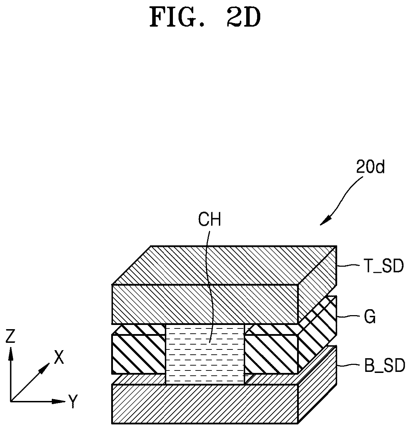

FIGS. 2A to 2D are diagrams illustrating examples of transistors according to some embodiments. For example, FIG. 2A shows a fin field-effect transistor (FinFET) 20a, FIG. 2B shows a gate-all-around field effect transistor (GAAFET) 20b, FIG. 2C shows a multi-bridge channel field effect transistor (MBCFET) 20c, and FIG. 2D shows a vertical field effect transistor (VFET) 20d. For convenience of illustration, FIGS. 2A to 2C show a state in which one of two source/drain regions is omitted to show a channel structure, and FIG. 2D shows a cross-section of the VFET 20d parallel to a plane formed by a Y axis and a Z axis and cut through a plane passing through a channel CH of the VFET 20d.

Referring to FIG. 2A, the FinFET 20a may be formed by a fin-shaped active pattern extending in an X-axis direction between shallow trench isolations (STIs) and a gate G extending in the Y-axis direction. A source/drain SD may be formed on each side of the gate G, and accordingly, the source/drains SD may be spaced apart from each other in an X-axis direction. An insulating layer may be formed between a channel CH and the gate G. In some embodiments, the FinFET 20a may be formed by a plurality of active patterns spaced apart from each other in the Y-axis direction and the gate G.

Referring to FIG. 2B, the GAAFET 20b may be formed by active patterns, e.g., nanowires, spaced apart from each other in the Z-axis direction and extending in the X-axis direction, and a gate G extending in the Y-axis direction. A source/drain SD may be formed on each side of the gate G, and accordingly, the source/drains SD may be spaced apart from each other in the X-axis direction. An insulating layer may be formed between a channel CH and the gate G. It is noted that the number of nanowires included in the GAAFET 20b is not limited to that shown in FIG. 2B.

Referring to FIG. 2C, the MBCFET 20c may be formed by active patterns, e.g., nanosheets, spaced apart from each other in the Z-axis direction and extending in the X-axis direction, and the gate G extending in the Y-axis direction. A source/drain SD may be formed on each side of the gate G, and accordingly, the source/drains SD may be spaced apart from each other in the X-axis direction. An insulating layer may be formed between a channel CH and the gate G. It is noted that the number of nanosheets included in the MBCFET 20c is not limited to that shown in FIG. 2C.

Referring to FIG. 2D, the VFET 20d may include a top source/drain T_SD and a bottom source/drain B_SD spaced apart from each other in the Z-axis direction with a channel CH disposed therebetween. The VFET 20d may include a gate G surrounding the periphery of the channel CH between the top source/drain T_SD and the bottom source/drain B_SD. An insulating layer may be formed between the channel CH and the gate G.

Hereinafter, an integrated circuit including the GAAFET 20b or the MBCFET 20c will be mainly described, but it is noted that elements included in the integrated circuit are not limited to the examples of FIGS. 2A to 2D. For example, an integrated circuit may include a ForkFET in which an N-type transistor and a P-type transistor have a closer structure as nanosheets for the P-type transistor and nanosheets for the N-type transistor are separated by a dielectric wall. In addition, the integrated circuit may include a bipolar junction transistor as well as a FET such as a complementary field effect transistor (CFET), a negative capacity field effect transistor (NCFET), a carbon nanotube (CNT) FET, etc.

FIG. 3 is a circuit diagram illustrating an amplifier 30 according to one or more embodiments. For example, the circuit diagram of FIG. 3 shows the amplifier 30 as an example of the device 10 of FIG. 1. As shown in FIG. 3, the amplifier 30 may include an input stage circuit 31, an output stage circuit 32, and a bias circuit 33. Hereinafter, descriptions of FIG. 3 redundant with those given above with reference to the drawings will be omitted.

The input stage circuit 31 may receive the first input signal IN1 and the second input signal IN2, and generate complementary signals, for example, a first amplification signal AMP1 and a second amplification signal AMP2, by amplifying a difference between the first input signal IN1 and the second input signal IN2. As shown in FIG. 3, the input stage circuit 31 may include first to fifth transistors M11 to M15. The first transistor M11 and the second transistor M12 may each be a p-channel field effect transistors (PFET), and the third to fifth transistors M13 to M15 may each be an n-channel field effect transistor (NFET).

The third transistor M13 may have a gate receiving the first input signal IN1, a drain connected to the first transistor M11, and a source connected to the fifth transistor M15. The fourth transistor M14 may have a gate receiving the second input signal IN2, a drain connected to the second transistor M12, and a source connected to the fifth transistor M15. The fifth transistor M15 may have a drain connected to the third transistor M13 and the fourth transistor M14, a source connected to a second power node to which a negative supply voltage VSS is applied, and a gate receiving a third bias voltage VB3. The fifth transistor M15 may function as a current source.

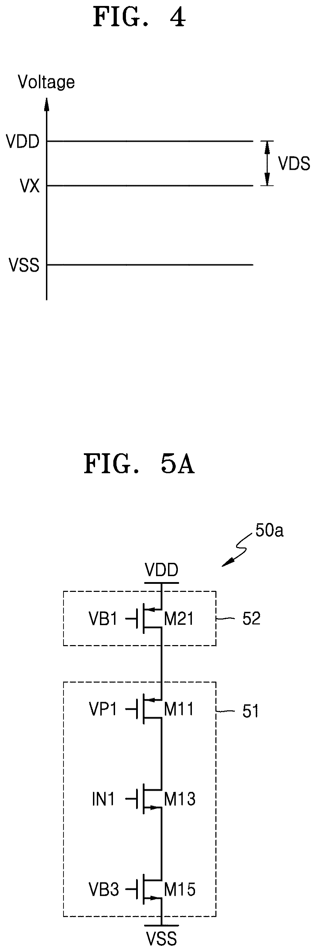

The first transistor M11 may have a source connected to a first node N1 where the first amplification signal AMP1 is generated, a drain connected to the third transistor M13, and a gate to which a first protection voltage VP1 is applied. The second transistor M12 may have a source connected to a second node N2 where the second amplification signal AMP2 is generated, a drain connected to the fourth transistor M14, and a gate to which the first protection voltage VP1 is applied. A voltage at each of the first node N1 and the second node N2 may be higher than or equal to the first protection voltage VP1 applied to the gate of each of the first transistor M11 and the second transistor M12. As will be described below with reference to FIG. 4, the first transistor M11 and the second transistor M12 may prevent a voltage higher than or equal to the withstand voltage from being applied to other transistors, for example, a first transistor M21 and a second transistor M22 of the output stage circuit 32. A transistor, such as the first transistor M11 and the second transistor M12, preventing the voltage higher than or equal to the withstand voltage from being applied to another transistor may be referred to as a protection transistor herein.

The output stage circuit 32 may receive the first amplification signal AMP1 and the second amplification signal AMP2, and may generate complementary signals, for example, a first output signal OUT1 and a second output signal OUT2, from the first amplification signal AMP1 and the second amplification signal AMP2, respectively. In some embodiments, the output stage circuit 32 may be of a single-ended type, and may output only the second output signal OUT2. As shown in FIG. 3, the output stage circuit 32 may include first to eighth transistors M21 to M28. The first to sixth transistors M21 to M26 may each be a PFET, and the seventh and eighth transistors M27 and M28 may each be an NFET.

The first transistor M21 may have a source connected to a first power node to which a positive supply voltage VDD is applied, a drain connected to the first node N1, and a gate to which a first bias voltage VB1 is applied. The second transistor M22 may have a source connected to the first power node, a drain connected to the second node N2, and a gate to which the first bias voltage VB1 is applied. Each of the first transistor M21 and the second transistor M22 may function as a current source.

The third transistor M23 may have a source connected to the first node N1, a drain connected to the fifth transistor M25, and a gate to which a second bias voltage VB2 is applied. The fourth transistor M24 may have a source connected to the second node N2, a drain connected to the sixth transistor M26, and a gate to which the second bias voltage VB2 is applied. The fifth transistor M25 may have a source connected to the third transistor M23, a drain connected to a first output node NO1 where the first output signal OUT1 is generated, and a gate to which a second protection voltage VP2 is applied. The sixth transistor M26 may have a source connected to the fourth transistor M24, a drain connected to a second output node NO2 where the second output signal OUT2 is generated, and a gate to which the second protection voltage VP2 is applied. Accordingly, the fifth transistor M25 and the sixth transistor M26 may be protection transistors, and a voltage at each of the sources of the fifth transistor M25 and the sixth transistor M26 may be higher than or equal to the second protection voltage VP2. In some embodiments, the second protection voltage VP2 may be the same as the first protection voltage VP1.

The seventh transistor M27 may have a drain and a gate connected to the first output node NO1, and a source connected to a second power node. The eighth transistor M28 may have a drain connected to the second output node NO2, a source connected to the second power node, and a gate connected to the first output node NO1. The seventh transistor M27 and the eighth transistor M28 may each function as a current mirror.

The bias circuit 33 may generate the first to third bias voltages VB1 to VB3. As shown in FIG. 3, the bias circuit 33 may include first to eighth transistors M31 to M38 and a current source CS. The first to third transistors M31 to M33 may each be a PFET, and the fourth to eighth transistors M34 to M38 may each be an NFET.

The current source CS may be connected to the first power node and the sixth transistor M36, and may provide a current having a predefined magnitude to the sixth transistor M36. The sixth to eighth transistors M36 to M38 and the fifth transistor M15 of the input stage circuit 31 may each function as a current mirror. The sixth transistor M36 may generate the third bias voltage VB3 corresponding to the current provided by the current source CS, and the seventh transistor M37, the eighth transistor M38, and the fifth transistor M15 of the input stage circuit 31 receiving the third bias voltage VB3 may generate currents proportional or corresponding to the current provided by the current source CS, respectively.

The second transistor M32, and the first and second transistors M21, M22 of the output stage circuit 32 may each function as a current mirror. The second transistor M32 may generate the first bias voltage VB1 corresponding to a current drawn by the seventh transistor M37, and the first and second transistors M21, M22 of the output stage circuit 32 receiving the first bias voltage VB1 may generate currents proportional or corresponding to the current drawn by the seventh transistor M37, respectively.

The third transistor M33, and the third transistor M23 and the fourth transistor M24 of the output stage circuit 32 may each function as a current mirror. The third transistor M33 may generate the second bias voltage VB2 corresponding to a current drawn by the eighth transistor M38, and the third transistor M23 and the fourth transistor M24 of the output stage circuit 32 receiving the second bias voltage VB2 may generate currents proportional or corresponding to the current drawn by the eighth transistor M38, respectively.

The first transistor M31 may have a source connected to the first power node to which the positive supply voltage VDD is applied, a drain connected to a node where the first bias voltage VB1 is generated, and a gate receiving an inverted power down signal PDB. The inverted power down signal PDB may correspond to an inverted version of the power down signal PD, and may be an active low signal. The inverted power down signal PDB may be inactivated in a normal mode to have a high level (e.g., VDD), while being activated in a power down mode to have a low level (e.g., VSS). When the inverted power down signal PDB is inactivated in the normal mode, the first transistor M31 may be turned off, and the first bias voltage VB1 may have a magnitude corresponding to the current drawn by the seventh transistor M37. In addition, when the inverted power down signal PDB is activated in the power down mode, the first transistor M31 may be turned on, and the first bias voltage VB1 may approximately correspond to the positive supply voltage VDD. The second transistor M32 of the bias circuit 33, and the first and second transistors M21, M22 of the output stage circuit 32 may be turned off and may not generate a current. Herein, the first transistor M31 may be referred to as a switch transistor.

When the voltages of the first node N1 and the second node N2 decrease due to the first bias voltage VB1 corresponding to the positive supply voltage VDD in the power down mode, source-drain voltages of the first transistor M21 and the second transistor M22 of the output stage circuit 32 may exceed the withstand voltage. However, as described above, the voltages of the first node N1 and the second node N2 may be maintained to be higher than or equal to the first protection voltage VP1 by the first transistor M11 and the second transistor M12 of the input stage circuit 31. Accordingly, source-drain voltages of the first transistor M21 and the second transistor M22 may be prevented from exceeding the withstand voltage. The fifth transistor M25 and the sixth transistor M26 receiving the second protection voltage VP2 may also protect the first transistor M21 and the second transistor M22 in the power down mode.

FIG. 4 is a graph illustrating a protection voltage according to one or more embodiments. For example, the graph of FIG. 4 shows a range to which the first to third protection voltages VP1 to VP3 of FIG. 3 belong. Hereinafter, FIG. 4 will be described with reference to FIG. 3.

As described above with reference to FIG. 3, the amplifier 30 may include a structure for preventing a voltage exceeding a withstand voltage from being applied to a transistor. For example, the input stage circuit 31 may include the first transistor M11 and the second transistor M12 receiving the first protection voltage VP1, the output stage circuit 32 may include the fifth transistor M25 and the sixth transistor M26 receiving the second protection voltage VP2, and the bias circuit 33 may include the fourth transistor M34 and the fifth transistor M35 receiving the third protection voltage VP3. The amplifier 30 may include a circuit generating the first to third protection voltages VP1 to VP3, or may receive the first to third protection voltages VP1 to VP3 from the outside.

The first to third protection voltages VP1 to VP3 may each have an appropriate size for protecting transistors. In some embodiments, the first transistor M21 and the second transistor M22 of the output stage circuit 32 may each have a withstand voltage VDS, and the first protection voltage VP1 for protecting the first transistor M21 and the second transistor M22 may be higher than or equal to a voltage VX reduced from the positive supply voltage VDD by the withstand voltage VDS. For example, the first protection voltage VP1 may approximately correspond to the voltage VX. In some embodiments, the second protection voltage VP2 may also approximately correspond to the voltage VX.

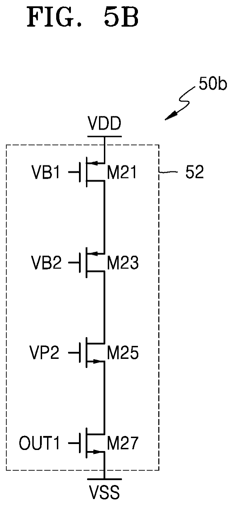

FIGS. 5A and 5B are circuit diagrams illustrating examples of current paths 50a and 50b according to some embodiments. For example, the circuit diagrams of FIGS. 5A and 5B illustrate current paths included in the amplifier 30 of FIG. 3. The amplifier 30 of FIG. 3 may include a plurality of current paths between the first power node to which the positive supply voltage VDD is applied and the second power node to which the negative supply voltage VSS is applied. Hereinafter, FIGS. 5A and 5B will be described with reference to FIG. 3.

Referring to FIG. 5A, the current path 50a may include a first transistor M21 of an output stage circuit 52, and a first transistor M11, a third transistor M13 and a fifth transistor M15 of an input stage circuit 51, which are connected in series between a first power node and a second power node. In a normal mode, the first transistor M21 of the output stage circuit 52 may generate a current based on a first bias voltage VB1, and the generated current may sequentially pass through the first transistor M11, the third transistor M13, and the fifth transistor M15 of the input stage circuit 51.

A source-drain voltage of each of the first transistor M21 of the output stage circuit 52 and the first transistor M11, the third transistor M13, and the fifth transistor M15 of the input stage circuit 51, which are connected in series between the first power node and the second power node, may be limited to a voltage obtained by dividing a difference between a positive supply voltage VDD and a negative supply voltage VSS. When a margin of the source-drain voltage of each of the first transistor M21 of the output stage circuit 52, and the first transistor M11, the third transistor M13 and the fifth transistor M15 of the input stage circuit 51 decreases, it may not be easy to enter a saturation region, and performance such as a gain of the amplifier 30 may be deteriorated. Accordingly, when the number of transistors connected in series in the current path 50a decreases, the margin of the source-drain voltage may increase, and performance of the amplifier 30 may increase or improve.

Referring to FIG. 5B, a current path 50b may include a first transistor M21, a third transistor M23, a fifth transistor M25, and a seventh transistor M27 of an output stage circuit 52, which are connected in series between a first power node and a second power node. In a normal mode, the first transistor M21 may generate a current based on a first bias voltage VB1, and the generated current may sequentially pass through the third transistor M23, the fifth transistor M25 and the seventh transistor M27.

A source-drain voltage of each of the first transistor M21, the third transistor M23, the fifth transistor M25 and the seventh transistor M27, which are connected in series between the first power node and the second power node may be limited to a voltage obtained by dividing a difference between a positive supply voltage VDD and a negative supply voltage VSS. As described above with reference to FIG. 5A, when a margin of the source-drain voltage of each of the first transistor M21, the third transistor M23, the fifth transistor M25 and the seventh transistor M27 decreases, it may not be easy to enter a saturation region, and performance of the amplifier 30 may be deteriorated. Accordingly, when the number of transistors connected in series in the current path 50b decreases, the margin of the source-drain voltage may increase, and the performance of the amplifier 30 may increase or improve.

As described above with reference to FIG. 3, the first transistor M11 of the input stage circuit 51 and the fifth transistor M25 of the output stage circuit 52 may protect transistors in a power down mode. Accordingly, as described below with reference to the drawings, when the first transistor M11 of the input stage circuit 51 and the fifth transistor M25 of the output stage circuit 52 are respectively omitted from the current paths 50a and 50b in the normal mode, each of the transistors included in the current paths 50a and 50b may have an extended margin of the source-drain voltage, and performance of the amplifier 30 may increase or improve.

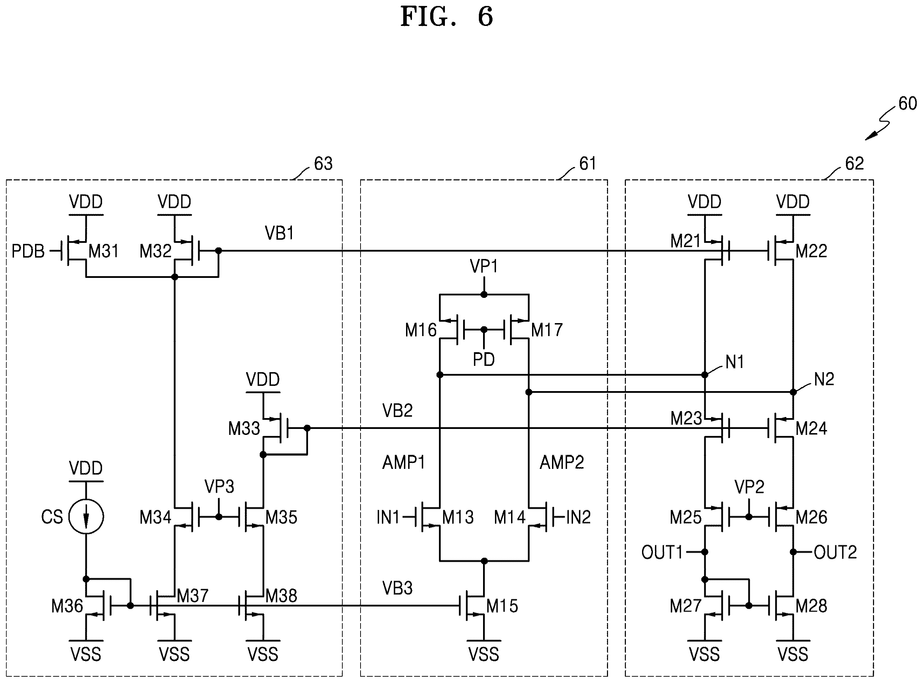

FIG. 6 is a circuit diagram illustrating an amplifier 60 according to one or more embodiments. For example, the circuit diagram of FIG. 6 shows an amplifier 60 as an example of the device 10 of FIG. 1. As shown in FIG. 6, the amplifier 60 may include an input stage circuit 61, an output stage circuit 62, and a bias circuit 63. Hereinafter, descriptions of FIG. 6 redundant with those given above with reference to the drawings will be omitted.

The input stage circuit 61 may receive a first input signal IN1 and a second input signal IN2, and generate complementary signals, for example, a first amplification signal AMP1 and a second amplification signal AMP2, by amplifying a difference between the first input signal IN1 and the second input signal IN2. As shown in FIG. 6, the input stage circuit 61 may include third to seventh transistors M13 to M17. The third to fifth transistors M13 to M15 may correspond to the third to fifth transistors M13 to M15 included in the input stage circuit 31 of FIG. 3, respectively.

Compared with the input stage circuit 31 of FIG. 3, the first transistor M11 and the second transistor M12 of FIG. 3 may be omitted from the input stage circuit 61 of FIG. 6, and the sixth transistor M16 and the seventh transistor M17 which are NFETs may be added. The sixth transistor M16 may have a source to which a first protection voltage VP1 is applied, a drain connected to a first node N1, and a gate receiving a power down signal PD. The seventh transistor M17 may have a source to which the first protection voltage VP1 is applied, a drain connected to a second node N2, and a gate receiving the power down signal PD.

In a normal mode, the sixth transistor M16 and the seventh transistor M17 may be turned off due to an inactivated power down signal PD, e.g., having a low level. Accordingly, the sixth transistor M16 and the seventh transistor M17 may not affect an operation of the amplifier 60 in the normal mode. In a power down mode, the sixth transistor M16 and the seventh transistor M17 may be turned on due to the activated power down signal PD, e.g., having a high level. Accordingly, voltages of the first node N1 and the second node N2 may be higher than or equal to the first protection voltage VP1, and transistors, for example, a first transistor M21 and a second transistor M22 of the output stage circuit 62 may be protected. In some embodiments, unlike shown in FIG. 6, the sixth transistor M16 and the seventh transistor M17 may be PFETs, and may each have gates that receive the inverted power down signal PDB.

The output stage circuit 62 may receive the first amplification signal AMP1 and the second amplification signal AMP2, and may generate complementary signals, e.g., a first output signal OUT1 and a second output signal OUT2, from the first amplification signal AMP1 and the second amplification signal AMP2. As shown in FIG. 6, the output stage circuit 62 may include first to eighth transistors M21 to M28. The first to eighth transistors M21 to M28 may correspond to the first to eighth transistors M21 to M28 included in the output stage circuit 32 of FIG. 3, respectively.

The bias circuit 63 may generate first to third bias voltages VB1 to VB3. As shown in FIG. 6, the bias circuit 63 may include first to eighth transistors M31 to M38 and a current source CS. The first to eighth transistors M31 to M38 and the current source CS may correspond to the first to eighth transistors M31 to M38 and the current source CS included in the bias circuit 33 of FIG. 3, respectively.

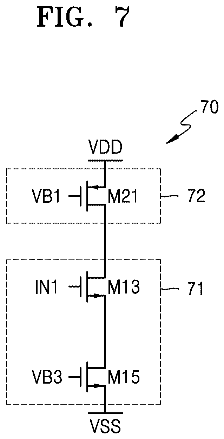

FIG. 7 is a circuit diagram illustrating a current path 70 according to one or more embodiments. For example, FIG. 7 illustrates a current path included in the amplifier 60 of FIG. 6. The amplifier 60 of FIG. 6 may include a plurality of current paths between a first power node to which the positive supply voltage VDD is applied and a second power node to which the negative supply voltage VSS is applied. Hereinafter, FIG. 7 will be described with reference to FIG. 6.

The current path 70 may include a first transistor M21 of an output stage circuit 72, and a third transistor M13 and a fifth transistor M15 of an input stage circuit 71, which are connected in series between a first power node and a second power node. In a normal mode, the first transistor M21 of the output stage circuit 72 may generate a current based on a first bias voltage VB1, and the generated current may sequentially pass through the third transistor M13 and the fifth transistor M15 of the input stage circuit 71.

A source-drain voltage of each of the first transistor M21 of the output stage circuit 72, and the third transistor M13 and the fifth transistor M15 of the input stage circuit 71 may be limited to a voltage obtained by dividing a difference between a positive supply voltage VDD and a negative supply voltage VSS. Compared with the current path 50a of FIG. 5A in which four transistors are connected between the first power node and the second power node, the first transistor M11 of FIG. 5A may be omitted in the current path 70 of FIG. 7, and each of the first transistor M21 of the output stage circuit 72, and the third transistor M13 and the fifth transistor M15 of the input stage circuit 71 may have an extended margin of the source-drain voltage, and performance of the amplifier 60 may increase or improve.

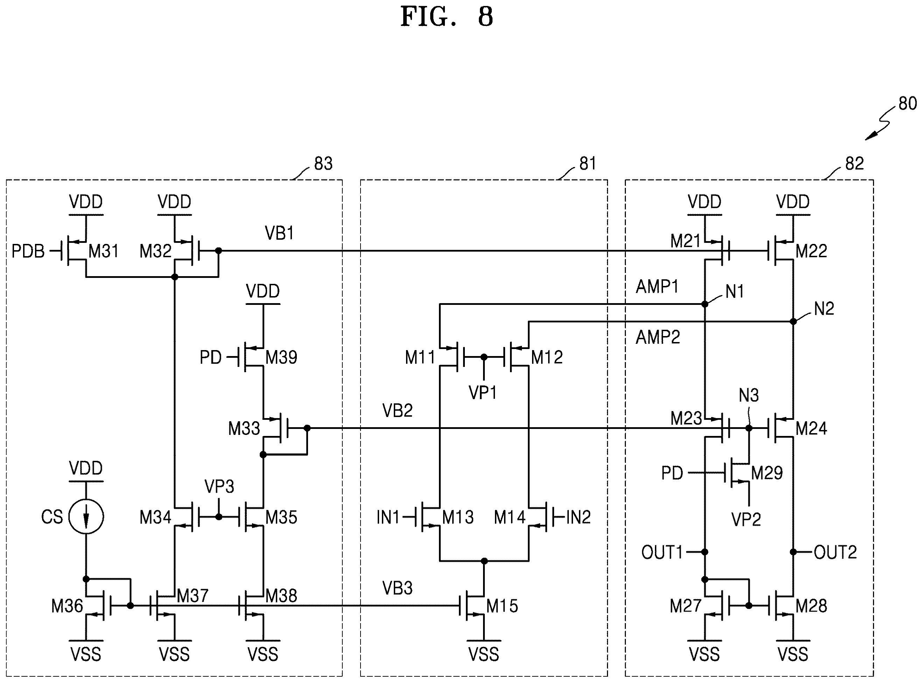

FIG. 8 is a circuit diagram illustrating an amplifier 80 according to one or more embodiments. For example, the circuit diagram of FIG. 8 shows an amplifier 80 as an example of the device 10 of FIG. 1. As shown in FIG. 8, the amplifier 80 may include an input stage circuit 81, an output stage circuit 82, and a bias circuit 83. Hereinafter, descriptions of FIG. 8 redundant with those given above with reference to the drawings will be omitted.

The input stage circuit 81 may receive a first input signal IN1 and a second input signal IN2, and generate complementary signals, e.g., a first amplification signal AMP1 and a second amplification signal AMP2, by amplifying a difference between the first input signal IN1 and the second input signal IN2. As shown in FIG. 8, the input stage circuit 81 may include first to fifth transistors M11 to M15. The first to fifth transistors M11 to M15 may correspond to the first to fifth transistors M11 to M15 included in the input stage circuit 31 of FIG. 3, respectively.

The output stage circuit 82 may receive the first amplification signal AMP1 and the second amplification signal AMP2, and may generate complementary signals, e.g., a first output signal OUT1 and a second output signal OUT2 from the first amplification signal AMP1 and the second amplification signal AMP2. As shown in FIG. 8, the output stage circuit 82 may include first to fourth transistors M21 to M24 and the seventh to ninth transistors M27 to M29. The first to fourth transistors M21 to M24, the seventh transistor M27 and the eighth transistor M28 may correspond to the first to fourth transistors M21 to M24, the seventh transistor M27 and the eighth transistor M28 included in the output stage circuit 32 of FIG. 3, respectively.

Compared with the output stage circuit 32 of FIG. 3, the fifth transistor M25 and the sixth transistor M26 of FIG. 3 may be omitted in the output stage circuit 82 of FIG. 8, and instead, the ninth transistor M29 which is an NFET may be added. The ninth transistor M29 may have a source to which a second protection voltage VP2 is applied, a drain connected to the third node N3, and a gate to which a power down signal PD is applied. The third node N3 may be a gate of the third transistor M23 and a gate of the fourth transistor M24.

In a normal mode, the ninth transistor M29 may be turned off due to an inactivated power down signal PD, e.g., having a low level. Accordingly, the ninth transistor M29 may not affect an operation of the amplifier 80 in the normal mode, and a second bias voltage VB2 generated by the bias circuit 83 may be applied to the gates of the third transistor M23 and the fourth transistor M24. In a power down mode, the ninth transistor M29 may be turned on due to an activated power down signal PD, e.g., having a high level. In addition, as will be described below, the bias circuit 83 may block the second bias voltage VB2 by floating the third node N3 where the second bias voltage VB2 is generated. Accordingly, a voltage of each of a first node N1 and a second node N2 may be higher than or equal to the second protection voltage VP2 by the third transistor M23 and the fourth transistor M24, and transistors, for example, the first transistor M21 and the second transistor M22 of the output stage circuit 82, may be protected. For example, the third transistor M23 and the fourth transistor M24 may contribute to generation of the first output signal OUT1 and the second output signal OUT2 according to the second bias voltage VB2 in the normal mode, while protecting the transistors from a voltage exceeding a withstand voltage in the power down mode. Herein, the third transistor M23 and the fourth transistor M24 may be referred to as multi-function transistors. In some embodiments, unlike shown in FIG. 8, the ninth transistor M29 may be a PFET and may have a gate receiving the inverted power down signal PDB. Compared with the output stage circuit 32 of FIG. 3, the output stage circuit 82 may include the reduced number of transistors.

The bias circuit 83 may generate the first to third bias voltages VB1 to VB3. As shown in FIG. 8, the bias circuit 83 may include first to ninth transistors M31 to M39 and a current source CS. The first to eighth transistors M31 to M38 and the current source CS may correspond to the first to the eighth transistors M31 to M38 and the current source CS included in the bias circuit 33 of FIG. 3, respectively.

Compared with the bias circuit 33 of FIG. 3, the ninth transistor M39 may be added in the bias circuit 83 of FIG. 8. The ninth transistor M39 may have a source to which a positive supply voltage VDD is applied, a drain connected to the third transistor M33, and a gate receiving the power down signal PD. In the normal mode, the ninth transistor M39 may be turned on due to the inactivated power down signal PD, e.g., having a low level. Accordingly, a current drawn by the eighth transistor M38 may pass through the ninth transistor M39, and the third transistor M33 may generate the second bias voltage VB2 corresponding to the current drawn by the ninth transistor M39. In the power down mode, the ninth transistor M39 may be turned off due to the activated power down signal PD, e.g., having a high level. Accordingly, a current drawn by the eighth transistor M38 may be blocked, and a node where the second bias voltage VB2 is generated (e.g., the third node N3) may be floating. Accordingly, the third node N3 may have the second protection voltage VP2 by the ninth transistor M29 of the output stage circuit 82 that is turned on in the power down mode. For example, in the power down mode, the second bias voltage VB2 may be approximately equal to the second protection voltage VP2. Herein, the ninth transistor M39 may be referred to as a switch transistor.

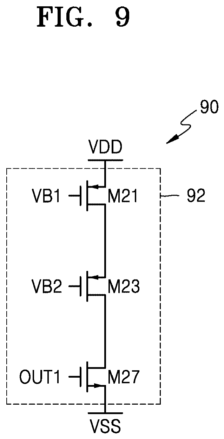

FIG. 9 is a circuit diagram illustrating a current path 90 according to one or more embodiments. For example, FIG. 9 illustrates a current path included in the amplifier 80 of FIG. 8. The amplifier 80 of FIG. 8 may include a plurality of current paths between a first power node to which a positive supply voltage VDD is applied and a second power node to which a negative supply voltage VSS is applied. Hereinafter, FIG. 9 will be described with reference to FIG. 8.

The current path 90 may include a first transistor M21, a third transistor M23 and a seventh transistor M27 of an output stage circuit 92, which are connected in series between the first power node and the second power node. In a normal mode, the first transistor M21 may generate a current based on a first bias voltage VB1, and the generated current may sequentially pass through the third transistor M23 and the seventh transistor M27.

A source-drain voltage of each of the first transistor M21, the third transistor M23 and the seventh transistor M27 may be limited to a voltage obtained by dividing a difference between a positive supply voltage VDD and a negative supply voltage VSS. Compared with the current path 50b of FIG. 5B in which four transistors are connected to each other between the first power node and the second power node, the fifth transistor M25 of FIG. 5B may be omitted in the current path 90 of FIG. 9, and each of the first transistor M21, the third transistor M23 and the seventh transistor M27 may have an extended margin of the source-drain voltage, and performance of the amplifier 60 may increase or improve.

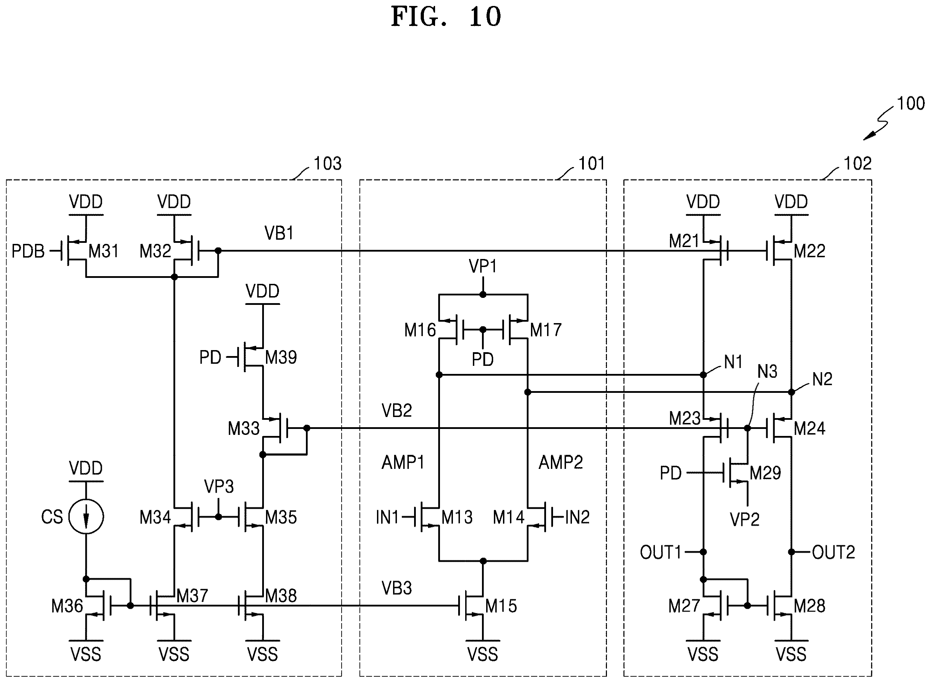

FIG. 10 is a circuit diagram illustrating an amplifier 100 according to one or more embodiments. For example, the circuit diagram of FIG. 10 shows an amplifier 100 as an example of the device 10 of FIG. 1. As shown in FIG. 10, the amplifier 100 may include an input stage circuit 101, an output stage circuit 102, and a bias circuit 103. Hereinafter, descriptions of FIG. 10 redundant with those given above with reference to the drawings will be omitted.

The input stage circuit 101 may receive a first input signal IN1 and a second input signal IN2, and generate complementary signals, e.g., a first amplification signal AMP1 and a second amplification signal AMP2, by amplifying a difference between the first input signal IN1 and the second input signal IN2. As shown in FIG. 10, the input stage circuit 101 may include third to seventh transistors M13 to M17. The third to seventh transistors M13 to M17 may correspond to the third to seventh transistors M13 to M17 included in the input stage circuit 61 of FIG. 6, respectively.

The output stage circuit 102 may receive the first amplification signal AMP1 and the second amplification signal AMP2, and may generate complementary signals, e.g., a first output signal OUT1 and a second output signal OUT2 from the first amplification signal AMP1 and the second amplification signal AMP2. As shown in FIG. 10, the output stage circuit 102 may include first to fourth transistors M21 to M24 and seventh to ninth transistors M27 to M29. The first to fourth transistors M21 to M24 and the seventh to ninth transistors M27 to M29 may correspond to the first to fourth transistors M21 to M24 and the seventh to ninth transistors M27 to M29 of the output stage circuit 82 of FIG. 8, respectively.

The bias circuit 103 may generate first to third bias voltages VB1 to VB3. As shown in FIG. 10, the bias circuit 103 may include first to ninth transistors M31 to M39 and a current source CS. The first to ninth transistors M31 to M39 and the current source CS may correspond to the first to ninth transistors M31 to M39 and the current source CS included in the bias circuit 83 of FIG. 8, respectively.

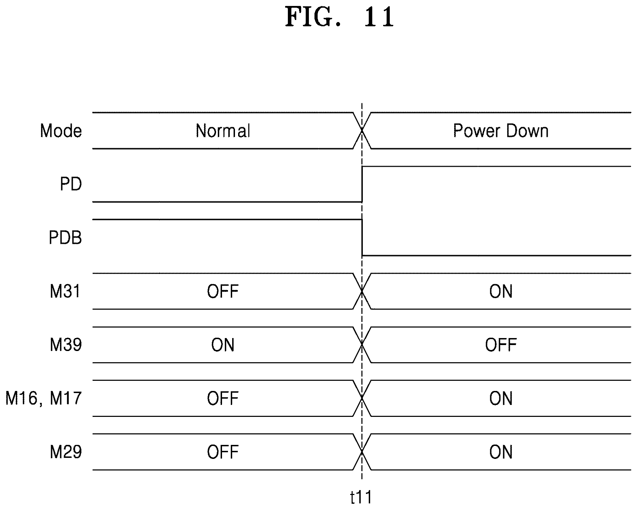

FIG. 11 is a timing diagram illustrating an operation of a device according to one or more embodiments. For example, the timing diagram of FIG. 11 shows states of the power down signal PD, the inverted power down signal PDB, the first and ninth transistors M31 and M39 of the bias circuit 103, the sixth transistor M16 and the seventh transistor M17 of the input stage circuit 101, and the ninth transistor M29 of the output stage circuit 102 in the amplifier 100 of FIG. 10 according to an operation mode. Hereinafter, FIG. 11 will be described with reference to FIG. 10.

Referring to FIG. 11, in the normal mode, the power down signal PD may be inactivated, and may have a low level as an active high signal. Due to the power down signal PD having the low level, the sixth transistor M16 and the seventh transistor M17 of the input stage circuit 101 may be turned off, and accordingly, the first protection voltage VP1 may be prevented from being applied to the first node N1 and the second node N2. In addition, due to the power down signal PD having the low level, the ninth transistor M29 of the output stage circuit 102 may be turned off, and accordingly, the second protection voltage VP2 may be prevented from being applied to the third node N3. In addition, due to the power down signal PD having the low level, the ninth transistor M39 of the bias circuit 83 may be turned on, and accordingly, the ninth transistor M39 may provide a current drawn by the eighth transistor M38.

The amplifier 100 before a time t11 may be set to a normal mode. In the normal mode, the inverted power down signal PDB may be inactivated, and may have a high level as an active low signal. Due to the inverted power down signal PDB having the high level, the first transistor M31 of the bias circuit 103 may be turned off, and accordingly, the positive supply voltage VDD may be prevented from being applied to a node where the first bias voltage VB1 is generated.

The amplifier 100 after the time t11 may be set to a power down mode. In the power down mode, the power down signal PD may be activated, and may have a high level as an active high signal. Due to the power down signal PD having the high level, the sixth transistor M16 and the seventh transistor M17 of the input stage circuit 101 may be turned on. Accordingly, the first node N1 and the second node N2 may each have a voltage higher than or equal to the first protection voltage VP1. In addition, due to the power down signal PD having the high level, the ninth transistor M29 of the output stage circuit 102 may be turned on. Accordingly, the second protection voltage VP2 may be applied to the third node N3, and the first node N1 and the second node N2 may have a voltage higher than or equal to the second protection voltage VP2 by the third transistor M23 and the fourth transistor M24. In addition, due to the power down signal PD having the high level, the ninth transistor M39 of the bias circuit 103 may be turned off, and accordingly, the current passing through the third transistor M33 may be blocked, and the second bias voltage VB2 may be blocked.

In the power down mode, the inverted power down signal PDB may be activated, and may have a low level as an active low signal. Due to the inverted power down signal PDB having the low level, the first transistor M31 of the bias circuit 103 may be turned on, and accordingly, the first bias voltage VB1 may be approximately equal to the positive supply voltage VDD. Due to the first bias voltage VB1 approximately equal to the positive supply voltage VDD, the second transistor M32 of the bias circuit 103, and the first transistor M21 and the second transistor M22 of the output stage circuit 102 may be turned off, and a current flowing from the first power node may be blocked.

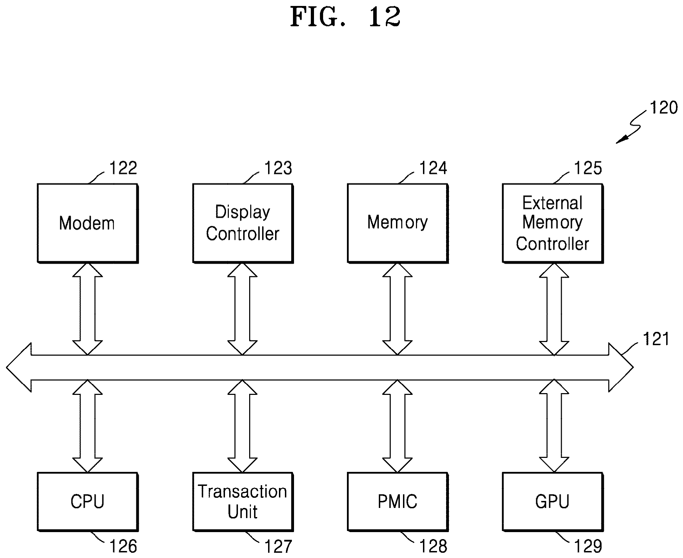

FIG. 12 is a block diagram illustrating a system-on-chip (SoC) 120 according to one or more embodiments. The SoC 120, which is a semiconductor device, may include a device according to one or more embodiments. The SoC 120 may include transistors as an implementation of complex blocks in one chip, such as an intellectual property (IP) that performs various functions. Referring to FIG. 12, the SoC 120 may include a modem 122, a display controller 123, a memory 124, an external memory controller 125, a central processing unit (CPU) 126, a transaction unit 127, a power management integrated circuit (PMIC) 128, and a graphic processing unit (GPU) 129, which may communicate to each other through a system bus 121.

The CPU 126 capable of controlling an operation of the SoC 120 at the highest layer may control operations of the modem 122, the display controller 123, the memory 124, the external memory controller 125, the CPU 126, the transaction unit 127, the PMIC 128, and the GPU 129. The modem 122 may demodulate a signal received from the outside of the SoC 120 or modulate a signal generated inside the SoC 120 and transmit the signal to the outside. The external memory controller 125 may control an operation of transmitting and receiving data from an external memory device connected to the SoC 120. For example, programs and/or data stored in the external memory device may be provided to the CPU 126 or the GPU 129 by the control of the external memory controller 125.

The GPU 129 may execute program instructions related to graphic processing. The GPU 129 may receive graphic data through the external memory controller 125, or may transmit the graphic data processed by the GPU 129 to the outside of the SoC 120 through the external memory controller 125. The transaction unit 127 may monitor a data transaction of each of the modem 122, the display controller 123, the memory 124, the external memory controller 125, the CPU 126, the transaction unit 127, the PMIC 128, and the GPU 129, and the PMIC 128 may control power supplied to each of the modem 122, the display controller 123, the memory 124, the external memory controller 125, the CPU 126, the transaction unit 127, the PMIC 128, and the GPU 129 by the control of the transaction unit 127. The display controller 123 may transmit data generated inside the SoC 120 to a display by controlling a display (or a display device) outside the SoC 120. The memory 124 may include a nonvolatile memory such as an electrically erasable programmable read-only memory (EPROM), flash memory, etc., or may include a volatile memory such as dynamic random access memory (DRAM), static random access memory (SRAM), etc.

At least one of components included in the SoC 120 may include a structure for protecting transistors from a voltage exceeding a withstand voltage. For example, at least one of the components included in the SoC 120 may include an analog circuit that processes an analog signal, and an analog circuit may include transistors and a structure for protecting transistors. The structure for protecting transistors may not affect an operation of the analog circuit in a normal mode, and may prevent the voltage exceeding the withstand voltage from being applied to the transistors in a power down mode. Accordingly, the transistors operating in the normal mode may not only be protected from the voltage exceeding the withstand voltage, but may also have an extended voltage margin, and as a result, the performance of the analog circuit may be increased or improved.

While the disclosure has been particularly shown and described with reference to embodiments thereof, it will be understood that various changes in form and details may be made therein without departing from the scope of the following claims.

Embodiments are set out in the following clauses:
Clause 1: A device comprising:
   a plurality of first transistors included in a first current path between a first power node to which a positive supply voltage is configured to be applied and a second power node to which a negative supply voltage is configured to be applied, in a normal mode; and
   a first protection transistor connected to a first node which two of the plurality of first transistors are connected to,
   wherein the first protection transistor is configured to be turned off in a normal mode, and to be turned on to provide a protection voltage to the first node in a power down mode.
Clause 2: The device of clause 1, wherein the two of the plurality of first transistors comprise a p-channel field-effect transistor (PFET) having a source connected to the first power node, a drain connected to the first node, and a gate receiving a bias voltage.
Clause 3: The device of clause 2, wherein the protection voltage is higher than or equal to a voltage reduced by a withstand voltage of the PFET from the positive supply voltage.
Clause 4: The device of clause 2, wherein the two of the plurality of first transistors comprise an n-channel field-effect transistor (NFET) having a drain connected to the first node.
Clause 5: The device of clause 2 or 3, further comprising:
   a switch transistor configured to, in the power down mode, provide a the positive supply voltage to the gate of the PFET.
Clause 6: The device of any preceding clause, wherein the first protection transistor comprises an NFET having a drain connected to the first node, a source to which the protection voltage is configured to be applied, and a gate configured to receive a control signal activated in the power down mode.
Clause 7: The device of any preceding clause, further comprising:
   a plurality of second transistors included in a second current path between the first power node and the second power node in the normal mode; and
   a second protection transistor connected to a second node which two of the plurality of second transistors are connected to,
   wherein the second protection transistor is configured to be turned off in the normal mode and to be turned on to provide the protection voltage to the second node in the power down mode.
Clause 8: The device of clause 7, wherein the first node and the second node are configured to generate complementary signals, respectively, in the normal mode.
Clause 9: A device comprising:
   a plurality of first transistors included in a first current path, in a normal mode, between a first power node to which a positive supply voltage is configured to be applied and a second power node to which a negative supply voltage is configured to be applied; and
   a protection transistor connected to a gate of a first multi-function transistor among the plurality of first transistors,
   wherein the protection transistor is configured to be turned off in the normal mode, and to be turned on to provide a protection voltage to the gate of the first multi-function transistor in a power down mode.
Clause 10: The device of clause 9, wherein the plurality of the first transistors comprise a p-channel field-effect transistor (PFET) having a source connected to the first power node, a drain connected to the first multi-function transistor, and a gate configured to receive a bias voltage.
Clause 11: The device of clause 10, wherein the protection voltage is higher than or equal to a voltage reduced by a withstand voltage of the PFET from the positive supply voltage.
Clause 12: The device of clause 10 or 11, further comprising:
   a switch transistor configured to, in the power down mode, provide a positive supply voltage to the gate of the PFET.
Clause 13: The device of clause 10, wherein the plurality of first transistors comprise an n-channel field effect transistor (NFET) having a source connected to the second power node and a drain connected to the PFET.
Clause 14: The device of any of clauses 9 to 13, wherein the gate of the first multi-function transistor is configured to receive a bias voltage in the normal mode.
Clause 15: A device comprising:
   an input stage circuit configured to, in a normal mode, generate complementary amplification signals from complementary input signals;
   an output stage circuit configured to, in the normal mode, generate complementary output signals from the complementary amplification signals; and
   a bias circuit configured to, in the normal mode, provide at least one bias voltage to each of the input stage circuit and the output stage circuit,
   wherein the input stage circuit comprises a first protection transistor and a second protection transistor respectively connected to a first node and a second node at which the complementary amplification signals are generated, respectively, and
   wherein the first protection transistor and the second protection transistor are configured to be turned off in the normal mode, and to be turned on to provide a first protection voltage to the first node and the second node, respectively, in a power down mode.

## Claims

1. A device (30) comprising:
an input stage circuit (31) configured to, in a normal mode, generate complementary amplification signals (AMP1, AMP2) from complementary input signals (IN1, IN2);
an output stage circuit (32) configured to, in the normal mode, generate complementary output signals (OUT1, OUT2) from the complementary amplification signals (AMP1, AMP2); and
a bias circuit (33) configured to, in the normal mode, provide at least one bias voltage (VB1, VB2, VB3) to each of the input stage circuit (31) and the output stage circuit (32),
wherein the input stage circuit (31) comprises a first protection transistor (M11) and a second protection transistor (M12) respectively connected to a first node (N1) and a second node (N2) at which the complementary amplification signals (AMP1, AMP2) are generated, respectively, and
wherein the first protection transistor (M11) and the second protection transistor (M12) are configured to be turned off in the normal mode, and to be turned on to provide a first protection voltage (VP1) to the first node (N1) and the second node (N2), respectively, in a power down mode.

2. The device (30) of claim 1, wherein the at least one bias voltage (VB1, VB2, VB3) comprises a first bias voltage (VB1), and
wherein the output stage circuit (32) comprises a first p-channel field-effect transistor, PFET, (M21) and a second PFET (M22) each having a gate configured to receive the first bias voltage (VB1), the first PFET (M21) and the second PFET (M22) being configured to provide currents to the first node (N1) and the second node (N2), respectively, from a first power node to which a positive supply voltage (VDD) is configured to be applied.

3. The device (30) of claim 2, wherein the first protection voltage (VP1) is higher than or equal to a voltage reduced by a withstand voltage of each of the first PFET (M21) and the second PFET (M22) from the positive supply voltage (VDD).

4. The device (30) of claim 2 or 3, wherein the bias circuit (33) comprises a first switch transistor (M31) configured to, in the power down mode, provide the positive supply voltage (VDD) to the gate of the first PFET (M21) and the gate of the second PFET (M22).

5. The device (30) of any of claims 2 to 4, wherein the input stage circuit (31) comprises a first n-channel field-effect transistor, NFET, (M13) and a second NFET (M14) configured to receive the complementary input signals (IN1, IN2), respectively, and connected to the first node (N1) and the second node (N2), respectively.

6. The device (100) of any of claims 2 to 4, wherein the at least one bias voltage (VB1, VB2, VB3) comprises a second bias voltage (VB2),
wherein the output stage circuit (32) comprises:
a first transistor (M23) and a second transistor (M24) respectively connected to the first node (N1) and the second node (N2), respectively connected to a first output node (NO1) and a second output node (NO2) at which the complementary output signals (OUT1, OUT2) are respectively generated, and respectively having gates configured to receive the second bias voltage (VB2) in the normal mode; and
a protection transistor (M29) connected to a gate of the first transistor (M23) and a gate of the second transistor (M24), and
wherein the protection transistor (M29) is configured to be turned off in the normal mode, and to be turned on in the power down mode to provide a second protection voltage (VP2) to each of the gate of the first transistor (M23) and the gate of the second transistor (M24).

7. The device (30) of claim 6, wherein the bias circuit (33) comprises:
a bias transistor (M33) configured to generate the second bias voltage (VB2); and
a second switch transistor (M39) configured to be turned on to provide the positive supply voltage (VDD) to the bias transistor (M33) in the normal mode, and to be turned off to block the positive supply voltage (VDD) from the bias transistor in the power down mode.

8. The device (30) of any preceding claim, wherein the first protection transistor (M11) and the second protection transistor (M12) are configured to be turned on to provide the first protection voltage (VP1) to the first node (N1) and the second node (N2), respectively, in the power down mode to maintain a voltage at the first node (N1) and a voltage at the second node (N2) to be higher than or equal to the protection voltage (VP1) to prevent the source-drain voltages of two of a plurality of transistors from exceeding a withstand voltage.
